# EUROPEAN PATENT APPLICATION

(11) **EP 1 841 304 A1**
(43) Date of publication of application: **03.10.2007**
(21) Application number: 06447047.9
(22) Date of filing: 31.03.2006
(51) Int. Cl.: H05K 5/02, E05D 3/06

(54) **A flat panel display wall**

(71) Applicant: BARCO N.V., 8500 Kortrijk (BE)
(72) Inventor: Mortier, Jan, 9800 Deinze (Astene) (BE)
(74) Representative: Bird, Ariane

(57) **Abstract**

A flat panel display wall as subject of the present invention comprises a frame, at least a first handle and a second handle and at least a first flat panel display having a bezel. The first handle is mounted on the bezel of the first display, the first and second handle are coupled to each other by means of a coupling system having at least one hinge. The hinge preferably has a first axis of rotation in front of the bezel.

## Description

### Technical field of the invention

The present invention relates flat panel display walls, such as racks, terminals or console mounts. In particular, the present invention is related to walls, such as racks, in which flat panel displays (such as e.g. LCD) are mounted one adjacent to the other. Behind the wall, e.g. in the rack, located behind the aligned flat panel displays, a multitude of electronic or other components may be located. The present invention also relates to methods to upgrade flat panel display walls and to methods to remove flat panel displays out of an aperture in a flat panel display wall. The present invention furthermore relates to a set of handles and to particular hinges.

### Background of the invention

It is known to have flat panel displays mounted so that they can be removed from a wall such as a rack.

It is also known, e.g. from US2003/161113, to provide a rack for modular electronic circuits wherein circuit boards are removable through an access opening or door substantially coextensive with the front face of the module. A hinge component for mounting an access door and a grip for extracting a module from a mounting rack is also described.

Although the doors can be opened completely to provide access to the circuit boards without obstructing any part of the door opening, the hinges for rotating the doors of the cabinet are mounted on the rack itself. The rack has to be provided so as to have enough space at its outer surface to enable the mounting of such hinges. This causes a loss of space at the front part of the rack.

Racks for mounting displays are known in the art, such as from US6802575.

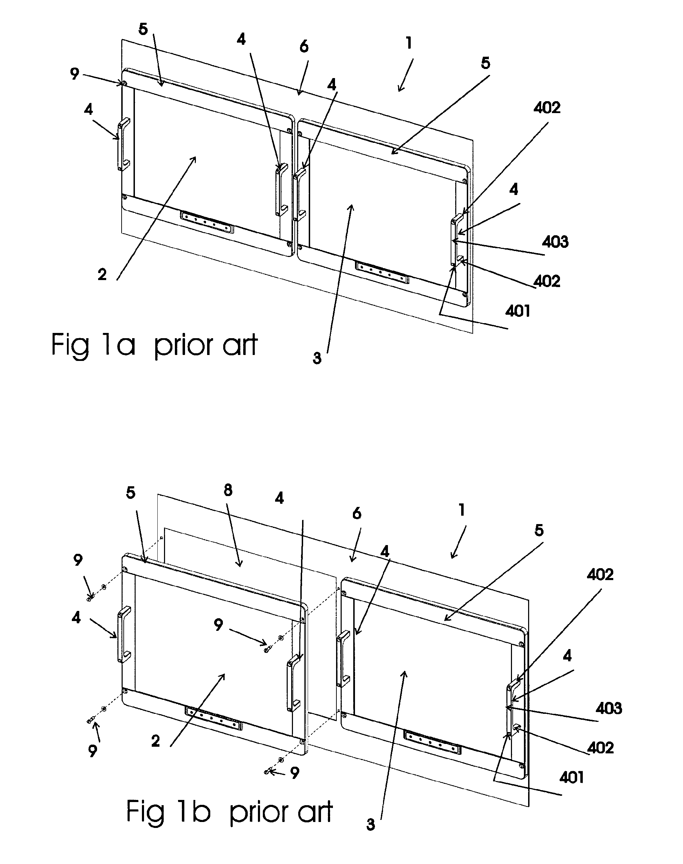

It is known to mount several displays, e.g. LCD- or CRT-displays one adjacent to the other. Rugged flat panel displays mounted in a rack or console leave, compared to CRT displays, room for the mounting of extra electronics or other components in the rack behind the display. To permit maintenance from the front side or to get to these electronics or other components mounted behind the displays, according to the state of the art, a display must be removed completely. Fig 1 a and Fig. 1 b show a typical flat panel display wall in which in this example two LCD panels are mounted in apertures of a frame which is part of such wall. Two displays 2 and 3 are mounted adjacent each other in a flat panel display wall 1, having a frame 6. Handles 4 are mounted to the bezels 5 of the displays 2, 3. The handles 4 are substantially U-shaped, having two support beams 402 connected to the bezels 5 and an intermediate part 403 interconnecting the two support beams 402. The handles are screwed to the bezel 5 using screws 401. The displays 2 and 3 are mounted in the apertures in the wall 1 with a number of bolts, e.g. typically 4 bolts 9 but alternatively another number of bolts, such as e.g. 2, 6 or 8 bolts may be used. In order to make the aperture 8 and the space behind the display 2 accessible, the bolts 9 of the display 2 are to be unscrewed, the display 2 is to be disconnected and put somewhere aside.

In order to facilitate the access to the cabling or electrical components behind the displays, GB 2366083 suggests a coupling of the flat panel display to the rack by means of hinges.

Such coupling has several disadvantages. Each display is to be provided with a hinge being coupled to the rack, which causes a loss of space at the front side of the rack. This causes that for existing racks this coupling may not be permissible or possible, because of necessary modifications which would negatively influence the rack stability or other rack properties. The flat panel displays are also to be dimensioned in order to fit with the other elements of the rack. Also, there may be a danger of flat panel displays falling back to their stable position, i.e. the position in which the display is facing outwards the rack in vertical position.

### Summary of the invention

It is an object of the present invention to provide an improved wall, such as a rack, terminal or console mount for displaying one or more flat panel displays, preferably ruggedized flat panel displays. The present invention provides walls in which flat panel displays (such as e.g. LCD) are mounted one adjacent to the other. In the wall, located behind the aligned flat panel displays within the frame of the wall, a multitude of electronic or other components may be located. An advantage of the present invention is to be able to reach these components easily, e.g. in case of malfunctioning or for maintenance.

A further advantage of the present invention is that moveable flat panel displays can be relocated in new and existing walls, such as racks, terminals or console mounts, displaying a multitude of flat panel displays one adjacent to the other. A further advantage of the present invention is a coupling system allowing flat panel displays to be moved, such as rotated, out of the wall, such as rack, terminal or console mount, without the necessity to disconnect the displays. A further advantage of the present invention is a coupling system allowing flat panel displays to be moved, such as rotated, out of the wall, such as rack, terminal or console mount, without the need of making modifications to the display dimensions or outer shape. A further advantage of the present invention is a coupling system allowing flat panel displays to be moved, such as rotated, out of the wall, such as rack, terminal or console mount, without the need to make modifications or to re-dimension the wall, so without modifying the walls, such as racks, terminals or console mounts properties. A further advantage of the present invention is a coupling system allowing flat panel displays to be moved, such as rotated, out of the wall, such as rack, terminal or console mount, providing unobstructed access to the space behind the moved display. A further advantage of the present invention is a system to allow entrance to the space behind a multitude of flat panel displays in a wall, such as rack, terminal or console mount without the need to remove the displays, and thus preventing that the removed displays get mixed up when they are to be mounted back in the wall.

A further advantage of the present invention is to be able to upgrade existing flat panel display walls, such as racks, terminals or console mounts comprising more than one display, allowing access to the space behind the displays while avoiding the necessity to completely remove a display when access is to be provided to the space behind said display.

A further advantage of the present invention is that the mechanical properties, e.g. strength and rigidity, of the flat panel display wall, the hinge, the handles and any other object of the present invention remain substantially unaffected.

According to a first aspect of the present invention, a wall, such as rack, terminal or console mount is provided which comprises a frame, at least a first and a second handle and at least a first flat panel display. The first flat panel display has a bezel; the first handle being mounted on the bezel of this flat panel display. According to the present invention, the first and second handle are coupled to each other by means of a coupling system having at least one hinge, which hinge preferably has a first axis of rotation in front of the bezel. Possibly the first axis of rotation of the hinge is located in front of the handle. Alternatively the first axis of rotation of the hinge is located between the bezel and the handle.

According to embodiments of the present invention, the second handle may be mounted to the frame.

According to embodiments of the present invention, a flat panel display wall, such as rack, terminal or console mount is provided which comprises a frame and at least two handles and at least a first and a second flat panel display, the first display being adjacent to the second display. Each of the flat panel displays has a bezel. The first handle is mounted on the bezel of the first display; the second handle is mounted to the bezel of the second display. According to embodiments of the present invention, the first and second handles may be coupled to each other by means of a coupling system having at least one hinge, which hinge preferably has a first axis of rotation in front of the bezels. Possibly the first axis of rotation of the hinge is located in front of the handle. Alternatively the first axis of rotation of the hinge is located between the bezel and the handle.

According to embodiments of the present invention, a flat panel display wall may comprise a frame and at least a first flat panel display having a bezel and a second flat panel display having a bezel. The bezel of this first display and the bezel of this second display may be coupled to each other by means of a coupling system having at least one hinge, which hinge preferably has a first axis of rotation in front of the bezel. Possibly each of the displays may be provided with at least one handle, which handle may be mounted to the bezel or possibly even to the hinge, which is mounted to the bezel. The axis of rotation of the hinge may be located between the bezels or may be located in front of the bezels. The hinge may be screwed to the bezels. In case the displays comprise handles, the screws used to mount the handles to the bezel of the display may as well be used to couple the hinge or hinges to the bezel. Possibly, in case at least one of the displays comprises handles mounted to its bezel, the handle may be removed from the bezel before rotating the display around the axis of the hinge, if such handle would obstruct the rotation of the display.

A hinge is to be understood as a coupling means having at least two arms for coupling two parts, each arm is for being coupled to one of these parts, said hinge allowing the two parts to rotate one versus the other around at least a first axis of rotation, each arm defining a plane which planes intersect along the first axis of rotation.

A flat panel display wall is to be understood as a wall along which the display screen or screens are visible along its surface in normal use, which surface may be substantially flat or curved along an arch. A wall may as well comprise a number of wall sections, which wall sections form angles between them. The display screens along the surfaces of two different wall sections may face each other or may be oriented away from each other. The wall comprises a frame, which provides the mechanical strength and structure to the wall. The frame has a front surface in which apertures are provided in which the flat panel displays may be located in such a way that the screens of the flat panel displays are substantially coplanar with the frame of the wall, or in such a way that the screens are provided in front of the frame, but still being substantially parallel to the surface of the frame of the wall. The frame creates a space, possibly an enclosed space, behind the apertures in which electronic or other components may be located.

A handle of the flat panel display wall is to be understood as a device facilitating the display to be held and moved during mounting of the display in the apertures present in the frame of the wall. Usually handles are U-, C- or bow-shaped profiles, possibly having two support beams and an intermediate element coupling the two support beams.

A frame is to be understood as the mechanical construction of the wall providing the mechanical stability of the wall and providing apertures in which the display panels are to be located.

A flat panel display wall may also comprise input means such as keyboard panels, touch screens or panels comprising one or a plurality of buttons or knobs, such as rotary or slide knobs, or similar input means.

The plat panel displays may be rugged or ruggedized panels, which is to be understood as fit for storing and use in harsh environments such as extreme temperatures, extreme humidity, extensive shocks or vibrations of subjected to high criteria regarding EMI and EMC, such as e.g. according to the MIL - STD 461 standard.

It is understood that a flat panel display wall may comprise additional elements, such as fixing means for fixing the displays to the frame of the wall, e.g. by means of bolts. Such fixing means may be subjected to standardised regulation patterns as e.g. set out in DIN41494 or EIA-310 standards.

According to embodiments of the present invention, the coupling system may be adapted to allow the flat panel displays to be moved, such as rotated out of the wall, without the necessity to disconnect the displays.

According to embodiments of the present invention, the coupling system may be adapted to allow a flat panel display to be moved, such as rotated out of the wall, without the need of making modifications to the display dimensions or outer shape.

According to embodiments of the present invention, the coupling system may be adapted to allow the flat panel displays to be moved, such as rotated out of the wall, without the need to make modifications or to re-dimension the wall, so without modifying the wall's properties.

According to embodiments of the present invention, the coupling system may be adapted to allow the flat panel displays to be moved, such as rotated out of the wall, to thereby provide unobstructed access to the space behind the so-moved display.

According to embodiments of the present invention, the wall may further comprise an entrance to the space behind the flat panel displays in the wall without the need to remove the displays.

According to embodiments of the present invention, the bezels may have an outer border and the hinge may be coupled to two neighbouring sides of the borders of adjacent bezels.

According to embodiments of the present invention, the axis of rotation of the hinge may be provided in front of the bezels. This way, when a first display is rotated out of the wall towards a second display provided in the wall, the first display fitting in an opening which has a circumference smaller than the bezel, which circumference is hidden by the bezel when the display is applied in the wall, the opening of the wall becomes completely unobstructed as the first display can be rotated towards the second display to a sufficient extent.

According to embodiments of the present invention, two or more hinges may be coupled to two neighbouring sides of the borders of adjacent bezels.

According to embodiments of the present invention, the hinges may be provided with damping means preventing the hinge to open or close under low forces. According to embodiments of the present invention, the hinges may be permanently fixed to the at least two displays. According to embodiments of the present invention, the hinge is a separate element of the wall, it may be possible to disconnect the hinge from two adjacent displays and couple the hinge to two other adjacent displays.

According to a second aspect of the present invention, a method to upgrade a flat panel display wall is provided, which wall comprises a frame and at least a first flat panel display and at least two adjacent handles, at least one of the two adjacent handles being mounted on the first flat panel display. The method comprises:
- providing a coupling system comprising a hinge having a first axis of rotation;
- coupling the two adjacent handles by means of the hinge, the first axis of rotation of the hinge being located in front of the handle and/or the bezel of the display.

According to embodiments of the present invention, the second handle may be mounted on the frame of the flat panel display wall. According to embodiments of the present invention, the wall may comprise at least a second flat panel display being adjacent to the first flat panel display, the second handle being mounted on the second adjacent flat panel display. According to embodiments of the present invention, the step of providing the coupling system may be a replacement of existing handles by handles having an incorporated hinge in accordance with an embodiment of the third aspect of the present invention. According to embodiments of the present invention, the step of providing the coupling system may be a provision to existing handles of a hinge in accordance to an embodiment of the fourth aspect of the present invention.

According to a third aspect of the present invention, a set of handles is provided, which set of handles comprise a first handle and a second handle, the first handle being coupled to the second handle by means of a hinge. The hinge may be coupled to the two handles by means of the same coupling means, e.g. the bolts, which are used to mount the handles to a surface.

According to a fourth aspect of the present invention, a hinge is provided, which hinge comprises a first hinge arm and a second hinge arm, the first arm and second arm being rotatably coupled to each other along a primary axis. The first arm is provided with a first coupling means for coupling this first arm to a surface, the first coupling means providing a handle to a surface when the first coupling means is coupled to the surface.

According to embodiments of the present invention, the first coupling means may comprise a first pair of support beams for being coupled to a surface, the first arm being coupled to the first pair of support beams, the first arm and first pair of support beams defining a handle. According to embodiments of the present invention, the first arm may be rotatably coupled to the first pair of support beams, allowing rotation along a secondary axis defined by the coupling points of the first arm and first pair of support beams. According to embodiments of the present invention, the second arm may be provided with a second coupling means for coupling the second arm to a surface, the second coupling means providing a handle to a surface when the second coupling means is coupled to the surface. According to embodiments of the present invention, the second coupling means may comprise a second pair of support beams for being coupled to a surface, this second arm being coupled to the second pair of support beams, the second arm and second pair of support beams defining a handle. According to embodiments of the present invention, the second arm may be rotatably coupled to the second pair of support beams, allowing rotation along a secondary axis defined by the coupling points of the second arm and second pair of support beams. According to embodiments of the present invention, the hinge may comprise at least one intermediate part, this intermediate part being rotatably coupled to the first arm and the second arm and located between this first and this second arm. Alternatively, each of both arms of the hinge may be coupled to a number of, e.g. two, supporting beams by means of bolts, which bolts are also the coupling means for coupling the supporting beams to a surface.

It is a fifth aspect of the present invention to provide a method to remove a flat panel display out of an aperture in a flat panel display wall, which method comprises:
- providing a hinge in accordance with the fourth aspect of the present invention;
- coupling the first arm to said display to be removed;
- coupling the second arm to said wall;
- rotating the first arm around the primary axis thereby removing the display from said aperture.

According to embodiments of the present invention, the second arm may be coupled to a second display, which second display is adjacent to the display to be removed.

According to embodiments of the present invention, the second arm may be coupled to a frame which frame is part of the wall.

According to a sixth aspect of the present invention, a hinge comprises a first hinge arm and a second hinge arm, the first arm and second arm are rotatably coupled to each other along a primary axis, the first arm being provided with a first coupling means for being rotatably coupled to a first handle.

According to embodiments of the present invention, the second arm may be provided with a second coupling means for being rotatably coupled to a second handle.

According to a seventh aspect of the present invention, a method is provided to remove out of an aperture in a flat panel display wall a flat panel display comprising a handle, which method comprises:
- providing a hinge according to the sixth aspect of the present invention;
- coupling the first arm to the handle of the display to be removed;
- coupling the second arm to the wall;
- rotating the first arm around the primary axis of the hinge, thereby removing the display from said aperture.

According to embodiments of the present invention, the second arm may be coupled to a handle being present on either the wall, or a second display, which second display is adjacent to the display to be removed.

Preferably the axis of rotation of the hinge is provided in such a way that the angle made by the screens of the two adjacent displays ranges from 180° to 40° , or even in the range of 180° to substantially 0°. 0° is to be understood as two displays having a display screen facing each other in a substantially parallel manner, whereas 180° is to be understood as two displays having their display screens coplanar.

According to embodiments of the present invention, the hinges may comprise more than one axis of rotation, such as two, three or four axes of rotation, which preferably are substantially parallel to each other. According to embodiments of the present invention, the dimensions of the arms of the hinge may be such that, when the display or displays to which the hinge is coupled are coplanar with the frame of the wall, the planes of the arms intersecting along the first axis compose an angle less than 180°, the angle being directed towards the wall. The presence of such multitude of axes and/or planes intersecting along the first axis, composing an angle less than 180°, the angle being directed towards the wall, may allow the display or displays to make also a translational movement in a direction substantially perpendicular to the wall surface, which facilitates the mounting or removal of the display from the aperture in the frame of the wall. It also facilitates to bridge a multitude of different distances between adjacent handles using only one hinge dimension.

The present invention permits access to the electronics or other components mounted behind the displays by allowing the display to hinge to the front side.

The bezels have an outer border. According to embodiments of the present invention where two handles are mounted to two adjacent displays, the hinge or hinges are coupled to two neighbouring sides of the borders of adjacent bezels via the handles. The adjacent displays may be located one next to the other in vertical or horizontal direction.

Because the axis of rotation is preferably provided in front of the bezels, when a first display is rotated out of the wall, such as rack, terminal or console mount, the opening of the wall, such as rack, terminal or console mount in which the display fits and which has a circumference smaller than the bezel and which circumference is hidden by the bezel, becomes completely unobstructed as the display can be rotated away to a sufficient extent.

It is understood that, dependent on the load of the flat panel displays which are rotated around the axis of the hinge, the number and dimensions of the hinge are to be selected appropriately. Possibly two or more hinges are coupled to the two neighbouring sides of the borders of adjacent bezels or to the frame adjacent to the bezel of a display.

The hinges may be provided with damping means preventing the hinge to open or close under low forces. This may be of importance when the wall, such as rack, terminal or console mount, is mounted in devices which can move, e.g. trucks, submarines, airplanes and other vehicles. Although the display is to be rotated out of the frame of the display occasionally, e.g. during service the display is rotated into service position, when the device is subjected to inclination, the hinges should not change position around their axes merely due to gravity forces acting upon the displays or due to shocks applied to the device.

The hinges may be provided with a locking means, maintaining the hinge, and thus the display, in its opened position and preventing the hinge to further open or close without interference of a person. The wall may possibly be provided with a means for preventing one or more flat panel displays to displace, i.e. rotate around the one or more axes of the hinge, when the one or more displays are rotated out of the frame of the wall using a hinge as subject of the present invention.

The axes of the hinge may be provided by a cylindrical element, rotatably mounted in a cylindrical housing. The axes may be provided with one or more swivel clips, such as DIN7993, which clips are for keeping arms and support beams together when transported as a set for mounting to a display (e.g. for an update).

The hinges may be permanently fixed to a pair of handles, or the hinge may be a separate element of the wall, such as rack, terminal or console mount, which hinge can be disconnected from two adjacent handles and coupled to two other adjacent handles when necessary. The hinge is then to be understood as a kit, which is to be used when a display has to be temporarily removed, i.e. rotated, out of the frame of the wall.

As it is possible to provide such a hinge to the flat panel displays of existing multi-display walls, such as racks, terminals or console mounts, existing walls, such as racks, terminals or console mounts, comprising at least two adjacent displays can be modified, i.e. upgraded, having at least one pair of flat panel displays being mounted rotatably one to the other by means of a hinge between a pair of adjacent handles, each of the adjacent handles being provided to the bezel of one of the adjacent displays.

According to embodiments of the present invention, a method to upgrade existing flat panel display walls is provided. The method comprises the step of providing a coupling system comprising a hinge to two adjacent handles, at least one of the two adjacent handles being mounted on a first flat panel display, the other handle being mounted on either a second flat panel display adjacent to the first flat panel display, or on the frame of the wall, the hinge having a first axis of rotation, which is in front of the handle and/or the bezel of the display. The step of providing the coupling system may be a replacement of the existing handles by handles having the hinge incorporated, or the step may be a provision of a hinge to the existing handles. Preferably, the method provides each of the displays from the wall to have at least one handle, which at least one handle is coupled to a hinge.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 a and Fig. 1 b shows two displays mounted in a flat panel display wall according to prior art.
Fig. 2 is a schematic view of a rack or console mount of an embodiment of the present invention comprising two adjacent flat panel displays in closed position.
Fig. 3 is a schematic view of the rack of Fig. 2, in half open position.
Fig. 4a and Fig. 4b shows details of the hinge as used in the embodiments according to Fig. 2 and Fig. 3 and Fig. 6 and Fig. 7.
Fig. 5 shows an alternative hinge as used in the embodiment according to Fig. 8 and Fig. 9.
Fig. 6 and Fig. 7 show an alternative embodiment of a flat panel display wall as subject of the present invention in closed position and in half-open position respectively.
Fig. 8 and Fig. 9 show an other alternative embodiment of a flat panel display wall as subject of the present invention in closed position and in half-open position respectively.
In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. Thus, the scope of the expression "a device A coupled to a device B" should not be limited to devices or systems wherein an output of device A is directly connected to an input of device B. It means that there exists a path between an output of A and an input of B which may be a path including other devices or means.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

The invention can typically be applied where two or more displays are mounted adjacent in a flat panel display wall, having a frame and handles mounted to their bezels.

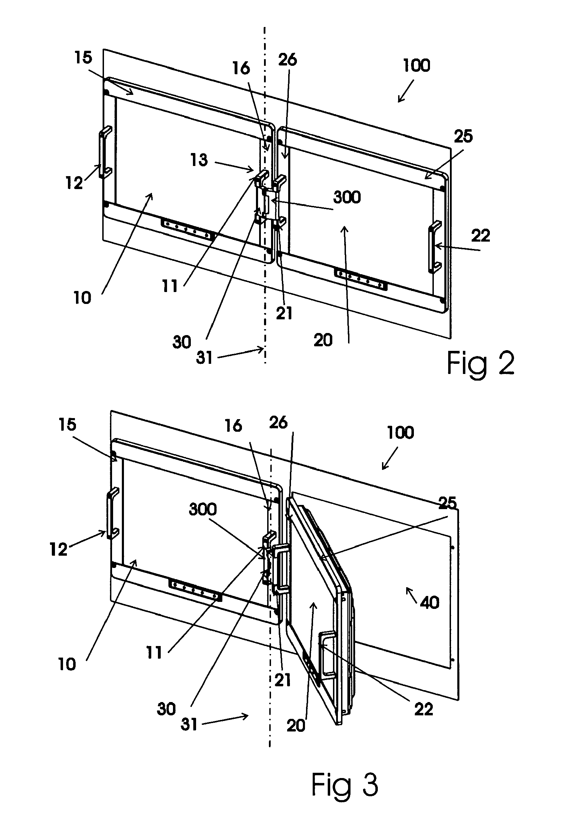

According to an aspect of the present invention, a coupling means having a hinge makes a bridge between two handles as shown in the figures 2 and 3 with a display in closed and half-open position.

A particular and preferred embodiment of the present invention is shown in Figure 2 and Figure 3, where a wall 100 has two adjacent flat panel displays 10 and 20. These are coupled by means of a coupling means having a hinge 30 which is coupled to the bezels of the flat panel displays. Each of the flat panel displays has at least two handles, handles 11 and 12 of the first display 10 and handles 21 and 22 of the second display 20, each handle being provided along a side of the bezel 15 or 25.

The displays are oriented in such a way that the two handles 13 and 21, one of each flat panel display, are provided along neighboring sides 16 and 26 of the two bezels 15 and 25 of the two flat panel displays 10 and 20. As shown in Fig. 2, the flat panel displays 10, 20 are in closed position and are mounted one adjacent to the other in horizontal position. In Fig. 3, the flat panel display is in substantially half open position. Identical features in both Fig. 2 and Fig. 3 are indicated with identical reference numbers.

The hinge 30 is provided to the two adjacent handles 13, 21. The hinge 30 is thus coupled to the bezels 15, 25 of the adjacent flat panel displays 10, 20 via the handles 13, 21. The axis 31 of the hinge 30 is located well before the bezels 15 and 25.

As shown in Fig. 3, the rotation of one of the displays 20 around the axis 31 of hinge 30, allows access to the space 40 located behind the frame 41 by rotation of the display 20.

The flat panel displays used may preferably be ruggedized flat panel displays such as LCD flat panel displays.

As an example, a flat panel display wall as subject of the invention comprises LCD flat panel displays of 19". These LCD panels are mounted matrix-like in a frame.

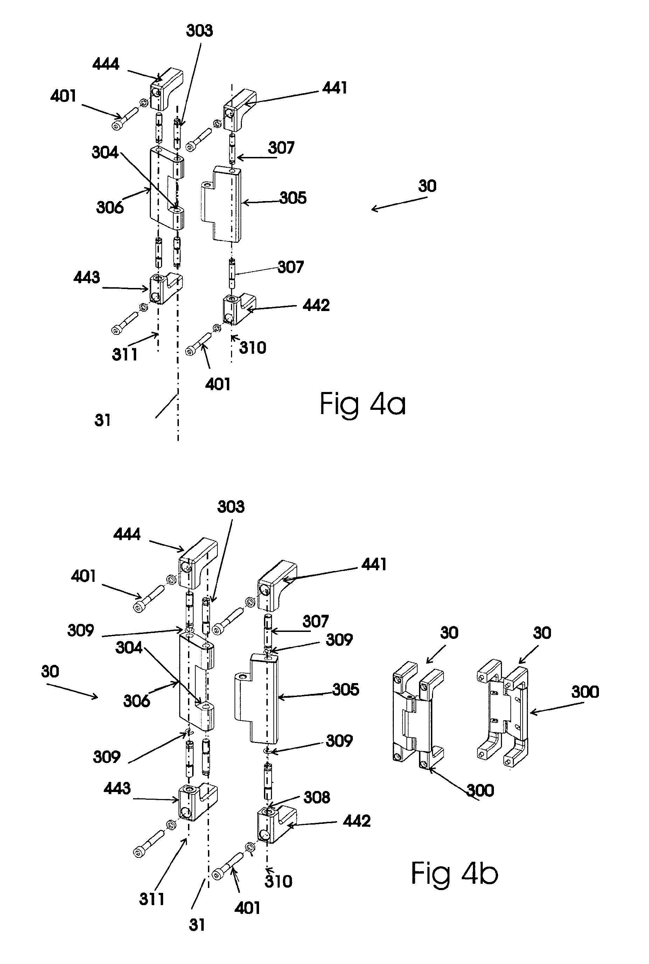

Throughout the figures 2 to 9, a set of handles 300 is shown which comprises two handles being coupled to each other by means of a hinge. The hinge can form part of the handles or can be a separate tool, which can be placed onto and removed from the handles. A detail of the hinge 30 as used in Fig. 2 and Fig. 3 is shown in Fig. 4a and Fig. 4b.

The hinge 30 comprises two arms 305 and 306 which each define a plane, which planes intersect along the first axis of rotation 31 of the hinge 30. The hinge 30 is provided with two cylindrical elements 303 (i.e. an upper and lower cylindrical element), each cylindrical element 303 being rotatably mounted in a corresponding cylindrical housing 304. The handles 4 of the prior art are replaced by similar elements which function as a coupling means to couple the hinge to a surface, in this case a display or the frame of the wall, which coupling means still function as handles. The coupling means comprises four support beams 441, 442, 443 and 444, which support beams are provided as individual elements in the embodiment illustrated. In alternative embodiments, the support beams can be formed integral with intermediate parts interconnecting the support beams, and onto which the arms 305, 306 are rotatably attached. In the example illustrated, the arms 306 and 305 are coupled to these support beams 441, 442, 443 and 444 by means of cylindrical elements 307, similar to the elements 303, which elements 307 are rotatably mounted in cylindrical housings 308, both in the support beams 441, 442, 443 and 444 and in the arms 305 and 306. A part of the arms 305 and 306 replaces the intermediate part 403 of the handle 4. The cylindrical elements 307 and the cooperating cylindrical housings 308 provide a secondary axis of rotation 310 and an other secondary axis of rotation 311 to the hinge, which secondary axes are defined by either the coupling points of the first arm 305 with the support beams 441 and 442, or the coupling points of the second arm 306 with the support beams 443 and 444. In an identical way, the handles being coupled to the hinge 30 may be mounted on the bezels by means of screws 401. Between the cylindrical elements 306 and cylindrical housing 307, swivel clips 309 may be mounted as shown in Fig. 4b.

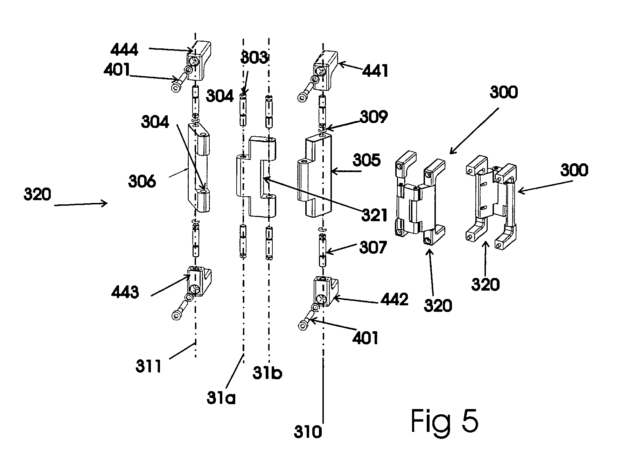

Fig. 5 shows an alternative hinge setup. Identical reference numbers refer to identical elements. The difference with the hinge 30 of Fig. 4, is that hinge 320 comprises four axes of rotation i.e. axes 310 and 311 being analogous to the axes referred to in Fig. 4 with the same reference, and axes 31 a and 31 b. Between the two arms 305 and 306, an intermediate part 321 is provided, and coupled to the arms 305 and 306 using analogous cylindrical elements 303 rotatably mounted in cylindrical housings 307. Between the cylindrical elements 306 and cylindrical housing 307, swivel clips 309 may be mounted. This extended hinge setup has the advantage that it can bridge a larger distance between adjacent handles.

As can be seen in Fig. 4a, Fig. 4b and Fig. 5, the hinges have at least three substantially parallel axes of rotation, i.e. axes 31, 310 and 311, and axes 31a, 31b, 310 and 311, respectively. The presence of these at least three axes of rotation enables the hinge to make a translational movement in a direction substantially perpendicular to the surface of the panel display and the surface of the wall. This allows the display to be displaced out of the plane of the frame of the wall, which facilitates a more easy displacement of the display out of the wall. Such translational movement is necessary in case the display bezels are provided with one or more location pins at the rear side of the bezel pointing towards the frame in which a number of location holes are provided for receiving said location pins. By a translational movement out of the surface of the frame, the pins are to be disconnected from the location holes, before the display can make a rotational movement around one of the axes of rotation of the hinge. Although in Fig. 4a, Fig. 4b and Fig. 5, the axes 31, 31 a and 31 b are shown being in front of both the bezels of the displays and the handles, an alternative hinge set-up can be provided having the axes 31, 31 a and 31 b being located between the bezels and the handles (not illustrated in the drawings). Such set-up has the same advantageous use for flat panel display walls as subject of the present invention.

With respect to the definition of location of the primary axis above, the term "in front" is to be understood as the axis or axes being located before the surface of the bezel or before the imaginary line defined by the coupling points of the two support beams and the arm. The term "between" is to be understood as the axis or axes being located before the surface of the bezel but behind an imaginary line defined by the coupling points of the two support beams and the arm.

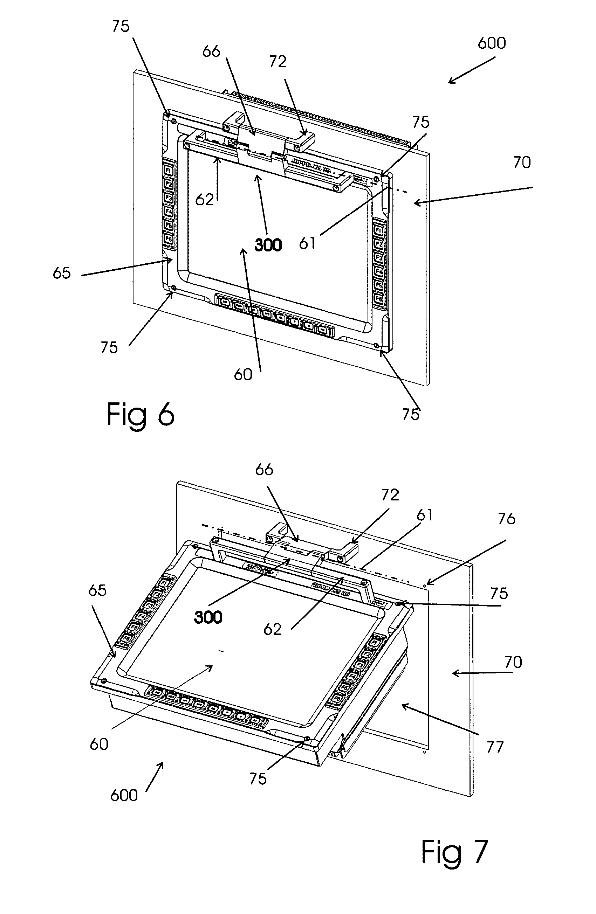

As can be seen in Fig. 2 and Fig. 3, as well as in Fig. 6 and Fig. 7, the arms 305 and 306 compose an angle α directed towards the wall, which is less than 180°, in the examples shown in the figures, being about 140°. The distance between the handles is as an example about 40 mm.

An alternative embodiment of a flat panel display wall 600 is shown in Fig. 6 in closed position and in Fig. 7 in half open position. A flat panel display 60 has one handle 62, which is coupled by means of a coupling means having a hinge 66 to a handle 72, which is mounted on the frame 70 of the wall 600. The hinge 66 is analogous to the one shown in Fig. 4. The hinge 66 has at least one axis of rotation 61. The handle 62 is mounted to the flat panel display 60 along the bezel 65 of the display 60. As best shown in Fig. 7, the display 60 can be fixed to the frame 70 by means of four screws 75 screwed in four cooperating holes 76 in the frame. As shown in Fig. 7, when the screws 75 are unlocked from the holes 76, the display can be rotated around the at least one axis 61 in order to provide entrance to the space 77 behind the display 60. Although in Fig. 6 and Fig. 7 the handles are positioned at the top side of the display, an alternative embodiment can be provided in identical way having the handles located at the bottom side of the display.

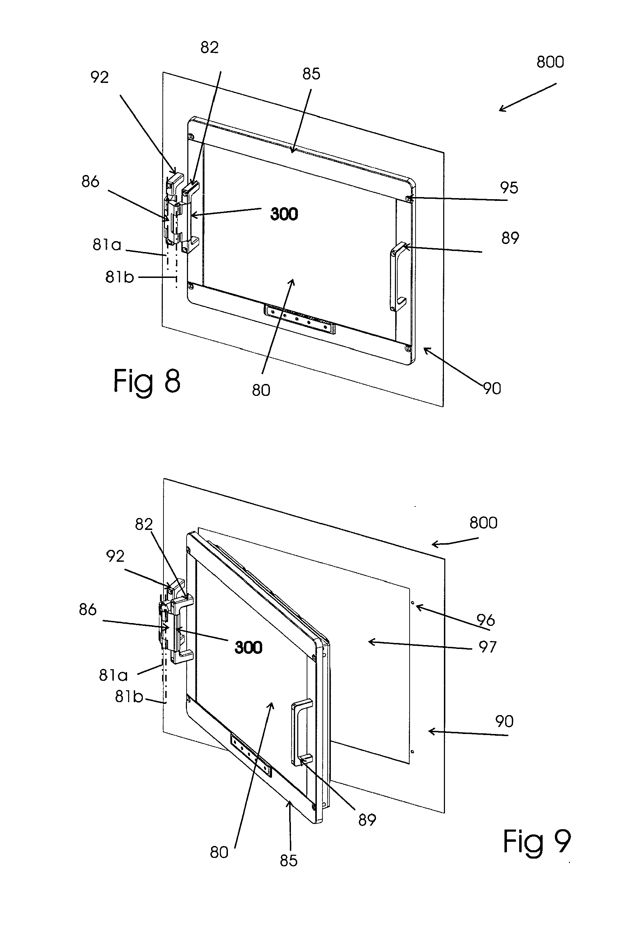

Still an other alternative embodiment of a flat panel display wall 800 is shown in Fig. 8 in closed position and in Fig. 9 in half open position. A flat panel display 80 has one handle 82, which is coupled by means of a coupling means having a hinge 86 to a handle 92, which is mounted on the frame 90 of the wall 800. The display 80 has a second handle 89. The hinge 86 is analogous to the one shown in Fig. 5. The hinge 86 has at least two axes of rotation 81 a and 81 b. The handle 82 is mounted on the flat panel display 80 along the bezel 85 of the display 80. As best shown in Fig. 9, the display 80 can be fixed to the frame 90 by means of four screws 95 screwed in four cooperating holes 96 in the frame. As shown in Fig. 9, when the screws 95 are unlocked from the holes 96, the display can be rotated around the axes 81 a and 81 b in order to provide entrance to the space 97 behind the display 80. Although in Fig. 8 and Fig. 9 the handles including a hinge means are positioned at the left side of the display, an alternative embodiment can be provided in an analogous way having the handles located at the right hand side of the display.

It is clear that the method to upgrade the existing flat panel display walls according to the present invention, may comprise the replacement of two adjacent handles 4 as illustrated in Fig. 1 by handles comprising a coupling means having a hinge e.g. as illustrated in Fig 2 and 3. No modifications to the displays bezels, nor to the frame are to be made.

As an alternative, a hinge may be clipped to two adjacent existing handles 4 in order to provided the facility of rotating the displays around at least one axis of rotation of the hinge. In this case, a hinge according to embodiments of the present invention, provided with clipping means is clipped onto the handles.

According to the present invention, a method to remove flat panel displays out of existing flat panel display walls, such as e.g. shown in Fig. 1 a and Fig. 1 b comprises the steps of replacing an existing pair of adjacent handles, one handle being located on the display to be removed, and another e.g. located on an adjacent display, by a hinge as subject of the present invention. In other words, via the hinge as subject of the present invention, a coupling is provided between the display to be removed and the wall, possibly via a second, adjacent display. The display to be removed is now disconnected from the wall, e.g. be unscrewing the fixing screws 9. The display to be removed stays coupled to the wall via the hinge applied in accordance with embodiments of the present invention. Rotating, and possibly translating the display from the frame around one or more axes of rotation of the hinge then removes the display from the frame, and thus from the wall, and provides entrance to the open space behind the removed display.

Alternatively, in case the flat panel display wall comprises displays without handles, a method to remove one of the displays can be provided by coupling a hinge having at least one handle function to the display to be removed. The hinge is coupled to the frame of the wall or to an adjacent display. As already set out above, the display to be removed can then be disconnected from the frame by e.g. unscrewing fixing screws and rotating and possibly translating the display to be removed along the axis or axes of rotation of the hinge provided.

The use of handles for coupling the hinge has the additional advantage that the handle functionalities remains as usual, being a help for mounting the flat panel displays in the wall, and as a grip for the operator when using the flat panel display wall. The latter may be of particular importance when the wall is mounted in devices, which can move, e.g. trucks, submarines, airplanes and many more.

The present invention has the additional advantages that no console or wall adaptation is necessary and no interference with console or wall aperture is needed. A further advantage is that left and right mounting options are available and can be provided easily. Additionally, the use of the standard display fixation holes so that there is no alteration to the known shock and vibration specifications is an advantage for allowing easy implementation of the invention, and enables the adaptation of existing multi-display walls.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A flat panel display wall comprising a frame, at least a first handle and a second handle and at least a first flat panel display having a bezel, the first handle being mounted on the bezel of said first display, wherein the first and second handle are coupled to each other by means of a coupling system having at least one hinge.

2. A wall according to claim 1, wherein the hinge has a first axis of rotation in front of the bezel.

3. A wall according to any of claims 1 or 2, wherein the hinge has a first axis of rotation in front of the first and second handles.

4. A wall according to any of the previous claims, wherein the second handle is mounted to the frame.

5. A wall according to any of claims 1 to 3, wherein the flat panel display wall comprises at least a second flat panel display, the first flat panel display being adjacent to the second flat panel display, said second flat panel display having a bezel, wherein the second handle is mounted to the bezel of the second display.

6. A wall comprising a frame and at least a first flat panel display having a bezel and a second flat panel display having a bezel, wherein the bezel of said first flat panel display and the bezel of said second flat panel display are coupled to each other by means of a coupling system having at least one hinge, which hinge has a first axis of rotation in front of the bezel.

7. A wall according to claim 6, wherein each of said displays is provided with at least one handle.

8. A wall according to any of claims 1 to 7, wherein the coupling system is adapted to allow the first flat panel display to be moved out of the wall without the necessity to disconnect the displays.

9. A wall according to any of claims 1 to 8, wherein the coupling system is adapted to allow the first flat panel display to be moved out of the wall without the need of making modifications to the display dimensions or outer shape.

10. A wall according to any previous claim, wherein the coupling system is adapted to allow the first flat panel display to be moved out of the wall without the need to make modifications to or to re-dimension the wall.

11. A wall according to any previous claim, wherein the coupling system is adapted to allow the first flat panel displays to be moved out of the wall, to thereby provide unobstructed access to the space behind the moved display.

12. A wall according to any previous claim, further comprising an entrance to the space behind the first flat panel displays in a wall without the need to remove the displays.

13. A wall according to any of claims 5 to 12, wherein the bezels have an outer border and the coupling system is attached to two neighbouring sides of the borders of adjacent bezels.

14. A wall according to any of claims 5 to 13, wherein the axis of rotation of the hinge is provided in front of the bezels, such that when the first display is rotated out of the wall towards the second display, the opening of the wall in which the first display fits and which has a circumference smaller than the bezel and which circumference is hidden by the bezel, becomes unobstructed.

15. A wall according to any previous claim, wherein the coupling system has two or more hinges.

16. A wall according to any previous claim, wherein the hinge is provided with damping means preventing the hinge to open or close under forces lower than a pre-determined threshold force.

17. A wall according to any of claims 5 to 16, wherein the hinges are permanently fixed to the at least two displays.

18. A wall according to any previous claim, wherein the hinge is a separate element of the wall, which hinge can be disconnected from two adjacent handles and coupled to two other adjacent handles.

19. A method to upgrade a flat panel display wall comprising a frame and at least a first flat panel display and at least two adjacent handles, at least one of the two adjacent handles being mounted on a first flat panel display, said method comprising:
- providing a coupling system comprising a hinge having a first axis of rotation;
- coupling the two adjacent handles by means of the hinge, the first axis of rotation of the hinge being located in front of the handle and/or the bezel of the display.

20. A method to upgrade a flat panel display wall according to claim 19, wherein said second handle is mounted on the frame of the flat panel display wall.

21. A method to upgrade a flat panel display wall according to claim 19, wherein said wall comprises at least a second flat panel display being adjacent to said first flat panel display, said second handle being mounted on the second adjacent flat panel display.

22. A method to upgrade a flat panel display wall according to any of claims 19 to 21, wherein the step of providing the coupling system is a replacement of existing handles by handles having an incorporated hinge.

23. A method to upgrade a flat panel display wall according to any of claims 19 to 21, wherein the step of providing the coupling system is a provision of a hinge to existing handles.

24. A set of handles comprising a first handle and a second handle, said first handle being coupled to said second handle by means of a hinge.

25. A hinge comprising a first hinge arm and a second hinge arm, said first hinge arm and said second hinge arm being rotatably coupled to each other along a primary axis, said first hinge arm being provided with a first coupling means for coupling said first hinge arm to a surface, said first coupling means providing a handle to a surface when said first coupling means is coupled to a surface.

26. A hinge as in claim 25, wherein said first coupling means comprises a first pair of support beams for being coupled to a surface, said first hinge arm being coupled to said first pair of support beams, said first hinge arm and first pair of support beams defining a handle.

27. A hinge as in claim 26, wherein said first hinge arm is rotatably coupled to said first pair of support beams, allowing rotation along a secondary axis defined by the coupling points of said first hinge arm and first pair of support beams.

28. A hinge as in any of claims 24 to 27, wherein said second hinge arm is provided with a second coupling means for coupling said second hinge arm to a surface, said second coupling means providing a handle to a surface when said second coupling means is coupled to a surface.

29. A hinge as in claim 28, wherein said second coupling means comprises a second pair of support beams for being coupled to a surface, said second hinge arm being coupled to said second pair of support beams, said second hinge arm and second pair of support beams defining a handle.

30. A hinge as in claim 29, wherein said second hinge arm is rotatably coupled to said second pair of support beams, allowing rotation along a secondary axis defined by the coupling points of said second hinge arm and second pair of support beams.

31. A hinge as in any of claims 25 to 30, wherein said hinge comprises at least one intermediate part, said intermediate part being rotatably coupled to said first hinge arm and said second hinge arm and located between said first and said second hinge arms.

32. A hinge comprising a first hinge arm and a second hinge arm, wherein said first hinge arm and second hinge arm are rotatably coupled to each other along a primary axis, said first hinge arm being provided with a first coupling means for being rotatably coupled to a first handle.

33. A hinge as in claim 32, wherein said second hinge arm is provided with a second coupling means for being rotatably coupled to a second handle.

34. A method to remove a flat panel display out of an aperture in a flat panel display wall, said method comprising the steps of
• providing a hinge as in any of claims 25 to 31;
• coupling said first hinge arm to said display to be removed;
• coupling said second hinge arm to said wall;
• rotating said first hinge arm around said primary axis thereby removing said display from said aperture.

35. A method as in claim 34, wherein said second hinge arm is coupled to a second display, which second display is adjacent to the display to be removed.

36. A method as in claim 34, wherein said second hinge arm is coupled to a frame which frame is part of said wall.

37. A method to remove a flat panel display comprising a handle out of an aperture in a flat panel display wall, said method comprising the steps of
• providing a hinge as in any of claims 32 to 33;
• coupling said first hinge arm to said handle of said display to be removed;
• coupling said second hinge arm to said wall;
• rotating said first hinge arm around said primary axis thereby removing said display from said aperture.

38. A method to remove a flat panel display as in claim 37, wherein said hinge is a hinge according to claim 33, said second hinge arm is coupled to a handle being present on either said wall, or a second display, which second display is adjacent to the display to be removed.
